# EUROPEAN PATENT APPLICATION

(11) **EP 4 807 051 A1**
(43) Date of publication of application: **16.09.2026**
(21) Application number: 24888717.6
(22) Date of filing: 06.11.2024
(51) Int. Cl.: C30B 29/04, B23K 26/53, C30B 33/04, H01L 21/02

(54) **METHOD FOR PROCESSING DIAMOND**

(30) Priority: 09.11.2023 JP 2023191748; 16.07.2024 JP 2024113206
(71) Applicant: Shin-Etsu Polymer Co., Ltd, Tokyo 100-0004 (JP); SHIN-ETSU CHEMICAL CO., LTD., Tokyo 100-0005 (JP); National University Corporation Saitama University, Saitama City, Saitama 338-8570 (JP)
(72) Inventor: IKENO, Junichi, Saitama-shi, Saitama 338-8570 (JP); YAMADA, Yohei, Saitama-shi, Saitama 338-8570 (JP); SUZUKI, Hideki, Saitama-shi, Saitama 331-0811 (JP); MATSUO, Rika, Saitama-shi, Saitama 331-0811 (JP); NOGUCHI, Hitoshi, Annaka-shi, Gunma 379-0195 (JP)
(74) Representative: MFG Patentanwälte Meyer-Wildhagen Meggle-Freund Gerhard PartG mbB
(86) International application number: PCT/JP2024/039355
(87) International publication number: WO 2025/100422

(57) **Abstract**

A modified layer can be formed along an arbitrary angle with respect to a {001} plane of a main surface on a single crystal diamond. In a method of processing diamond, a laser condenser 119 configured to condense laser light B is arranged to face a {001} plane of a main surface 10a of a single crystal diamond substrate 10, and the laser light is condensed inside the substrate 10 by the laser condenser 119 to form a modified layer extending at an angle with respect to the {001} plane toward the main surface 10a of the substrate 10, to thereby form a modified layer, which includes processing marks obtained by condensing the laser light B by the laser condenser 119 and pyrolyzing diamond into graphite and cleavages on a {111} plane formed around the processing marks, along a plane having an angle with respect to the {001} plane toward the main surface 10a of the substrate 10.

## Description

### TECHNICAL FIELD

The present invention relates to a method of processing diamond, more specifically, to a method of processing diamond by processing single crystal diamond using laser light.

### BACKGROUND ART

Conventionally, silicon carbide (SiC) and gallium nitride (GaN) have been provided as semiconductor materials suitable for power devices instead of silicon (Si). However, compared with conventional semiconductor materials, a diamond semiconductor is attracting attention as a next-generation semiconductor material due to higher dielectric breakdown electric field and power control index as well as the highest thermal conductivity, and research and development for practical application are in progress. Nitrogen-vacancy centers (NV centers) in diamond, enabling highly sensitive magnetic detection at room temperature, have been researched and are expected to be applied to magnetic sensors (see Patent Literature 1).

Single crystal diamond, which is expected to be applied to semiconductors, is synthesized by a high-temperature high-pressure method (HPHT method) or homoepitaxial growth, but these synthesis methods have difficulty in enlarging the area of a bulk substrate of single crystal diamond for use in semiconductor processes. Therefore, a vapor phase synthesis method (CVD method) that enables heteroepitaxial growth of single crystal diamond using single crystal magnesium oxide (MgO) as a base crystal, has been applied due to its superiority in enlarging the area.

Further, a method of manufacturing a diamond substrate from a diamond ingot using laser light has been disclosed (see Patent Literature 2). In this method, a modified layer having a modified crystal structure is formed by condensing laser light and irradiating the diamond ingot with the laser light to a predetermined depth from a main surface of the diamond ingot, and scanning the diamond ingot in two dimensions. A diamond substrate is stripped off from the modified layer.

### CITATION LIST

### PATENT LITERATURE

Patent Literature 1: Japanese Unexamined Patent Application Publication No. 2015-59069
Patent Literature 2: Japanese Unexamined Patent Application Publication No. 2020-50563

### SUMMARY OF THE INVENTION

### TECHNICAL PROBLEM

Single crystal diamonds have a property that cleavage progresses easily along a {111} plane, and when laser light is scanned in a two-dimensional manner on diamond ingots or blocks, a modified layer develops on the {111} plane that is a cleavage plane, making cleavage likely to occur on the {111} plane. For this reason, it has been difficult to form a modified layer along crystal faces other than the {111} plane.

This invention has been proposed in view of the above-described circumstances, and an object is to provide a method of processing diamond that can form a modified layer along an arbitrary angle with respect to a main surface {001} of a single crystal diamond.

### SOLUTION TO PROBLEM

To solve the above problems, a method of processing diamond according to the present application includes: a step of arranging a laser condenser configured to condense laser light, to face a {001} plane of a main surface of a single crystal diamond substrate; and a step of forming a modified layer extending at an angle with respect to the {001} plane toward the main surface of the substrate by condensing the laser light inside the substrate by the laser condenser, wherein in the step of forming the modified layer, the modified layer, which includes processing marks obtained by condensing the laser light by the laser condenser and pyrolyzing diamond into graphite and cleavages on a {111} plane formed around the processing marks, is formed along a plane having an angle with respect to the {001} plane toward the main surface of the substrate.

In the step of forming the modified layer, the modified layer may be formed so that cleavage planes formed along crystal faces constituting the {111} plane are connected to each other and extend along a plane having an angle with respect to the {001} plane toward the main surface of the substrate. In the step of forming the modified layer, the laser light is condensed by the laser condenser, a first scanning line and a second scanning line formed of the processing marks are formed from an end toward a tip of each wedge structure in a first crystal face and a second crystal face that form a wedge structure whose tip becomes thinner toward the main surface inside the substrate among the crystal faces constituting the {111} plane, and the first scanning line and the second scanning line may converge at the tip of the wedge structure to be connected to each other.

The first scanning line and the second scanning line include a first side and a second side that are adjacent to each other, and a length ratio between the first side and the second side may be set with respect to an angle of the modified layer toward the main surface of the substrate. In the step of forming the modified layer, after the first scanning line and the second scanning line are formed, the first scanning line and the second scanning line spaced apart by a predetermined interval in a direction in which the tip of the wedge structure extends may be further formed.

In the step of forming the modified layer, the laser light is condensed by the laser condenser, and, in a first crystal face and a second crystal face that form a wedge structure whose tip becomes thinner toward the main surface inside the substrate among the crystal faces constituting the {111} plane, a first scanning line and a second scanning line formed of the processing marks may be formed in a direction in which each tip of the wedge structure extends. In the step of forming the modified layer, after the first scanning line and the second scanning line are formed, the first scanning line and the second scanning line spaced apart by a predetermined interval toward the tip of the wedge structure may be further formed.

In the step of forming the modified layer, a modified layer including multiple planes having different angles with respect to the {001} plane toward the main surface of the substrate may be formed as a modified layer having a three-dimensional structure in which cleavages are each formed along the multiple planes and the multiple planes are connected. In the step of forming the modified layer, the laser light is condensed by the laser condenser, a first scanning line and a second scanning line formed of the processing marks are formed from an end toward a tip of each wedge structure in a first crystal face and a second crystal face that form a wedge structure whose tip becomes thinner toward the main surface inside the substrate among the crystal faces constituting the {111} plane, the first scanning line and the second scanning line converge at the tip of the wedge structure to be connected to each other, the first scanning line and the second scanning line include a first side and a second side that are adjacent to each other, and the wedge structure having a different length ratio between the first side and the second side that are adjacent to each other may be provided. The substrate may be separated by the modified layer.

### ADVANTAGEOUS EFFECTS OF INVENTION

According to the present invention, it is possible to form a modified layer along an arbitrary angle with respect to a {001} plane of a main surface on a single crystal diamond, and to separate the single crystal diamond by the modified layer along this angle.

### BRIEF DESCRIPTION OF DRAWINGS

[FIG. 1] FIG. 1 is a perspective view illustrating a schematic configuration of a processing device.
[FIG. 2] FIG. 2 is a plan view of a substrate to be processed by a processing device.
[FIG. 3] FIG. 3 is a schematic diagram illustrating arrangement of a {111} plane in a substrate.
[FIG. 4A] FIG. 4A is a diagram illustrating formation of cleavage in a substrate.
[FIG. 4B] FIG. 4B is a diagram illustrating formation of cleavage in a substrate.
[FIG. 5A] FIG. 5A is a diagram illustrating a processing method of the present embodiment.
[FIG. 5B] FIG. 5B is a diagram illustrating a processing method of the present embodiment.
[FIG. 6A] FIG. 6A is a diagram illustrating a scanning method of laser light.
[FIG. 6B] FIG. 6B is a diagram illustrating a scanning method of laser light.
[FIG. 7A] FIG. 7A is a diagram illustrating an aspect of a modified layer.
[FIG. 7B] FIG. 7B is a diagram illustrating an aspect of a modified layer.
[FIG. 7C] FIG. 7C is a diagram illustrating an aspect of a modified layer.
[FIG. 8] FIG. 8 is a diagram illustrating a processing method of Experiment 1.
[FIG. 9A] FIG. 9A is a photomicrograph of a substrate processed by the processing method of Experiment 1.
[FIG. 9B] FIG. 9B is a photomicrograph of a substrate processed by the processing method of Experiment 1.
[FIG. 10A] FIG. 10A is a photomicrograph of a substrate processed by the processing method of Experiment 2.
[FIG. 10B] FIG. 10B is a photomicrograph of a substrate processed by the processing method of Experiment 2.
[FIG. 10C] FIG. 10C is a photomicrograph of a substrate processed by the processing method of Experiment 2.
[FIG. 11] FIG. 11 is a diagram illustrating a processing method of Experiment 3.
[FIG. 12A] FIG. 12A is a photomicrograph of a substrate processed by the processing method of Experiment 3.
[FIG. 12B] FIG. 12B is a photomicrograph of a substrate processed by the processing method of Experiment 3.
[FIG. 13A] FIG. 13A is a diagram illustrating a substrate separated by the processing method of Experiment 3.
[FIG. 13B] FIG. 13B is a photograph of a separated portion of a substrate separated by the processing method of Experiment 3.
[FIG. 13C] FIG. 13C is a graph showing the measurement results of a surface shape of a stripped surface of a substrate separated by the processing method of Experiment 3.
[FIG. 14] FIG. 14 is a diagram illustrating another example of the processing method of the present embodiment.
[FIG. 15] FIG. 15 is a perspective schematic diagram illustrating a modified layer formed by the method illustrated in FIG. 14.

### DESCRIPTION OF EMBODIMENTS

Next, embodiments of the present invention will be described with reference to the drawings. In the following description of the drawings, identical or similar parts are denoted by identical or similar reference numerals. However, it should be noted that the drawings are schematic, and the relationship between the thickness and the plane dimension, the ratios of the thickness of layers, or the like, are different from the actual ones. Therefore, specific thicknesses and dimensions should be determined with reference to the following description. Also, it is needless to say that portions having different dimensional relationships and ratios among the drawings are included.

Further, the following embodiments illustrate a device and a method for embodying the technical concept of the present invention, and the embodiments of the present invention do not specify the following materials, shapes, structures, arrangements, or the like, of components. Various modifications may be made to the embodiments of the present invention within the scope of the claims.

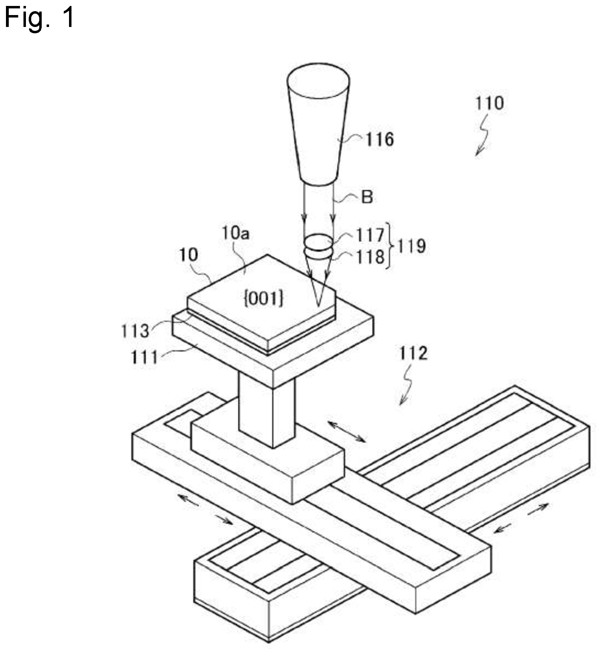

FIG. 1 is a perspective view illustrating a schematic configuration of a processing device 110 used in a method of processing diamond of the present embodiment. The processing device 110 includes a stage 111 on which a single crystal diamond substrate 10 is placed, a stage support 112 for supporting the stage 111 to be movable in an XY direction in a horizontal plane, and a fixture 113 for fixing the single crystal diamond substrate 10. An adhesive layer, a mechanical chuck, an electrostatic chuck, a vacuum chuck, or the like can be applied to the fixture 113.

The plate-like substrate 10 having a rectangular outer periphery, which is formed by cutting a single crystal diamond ingot to a predetermined length as an object to be processed, is fixed on the stage 111, where a {001} plane having an off-angle of 0 degrees, which is a main surface, serves as a main surface 10a of an upper surface. The shape of the object to be processed is not limited to the description above, and may be, for example, a single crystal diamond ingot, a wafer in a disc shape, or may be a bulk crystal of single crystal diamond, as long as the main surface 10a is the {001} plane.

The processing device 110 includes a laser light source 116 for generating pulsed laser light, and a laser condenser 119 including an objective lens 117 and an aberration adjusting section 118. Laser light B emitted from the laser light source 116 is emitted toward the {001} plane of the main surface 10a of the single crystal diamond substrate 10 via the laser condenser 119.

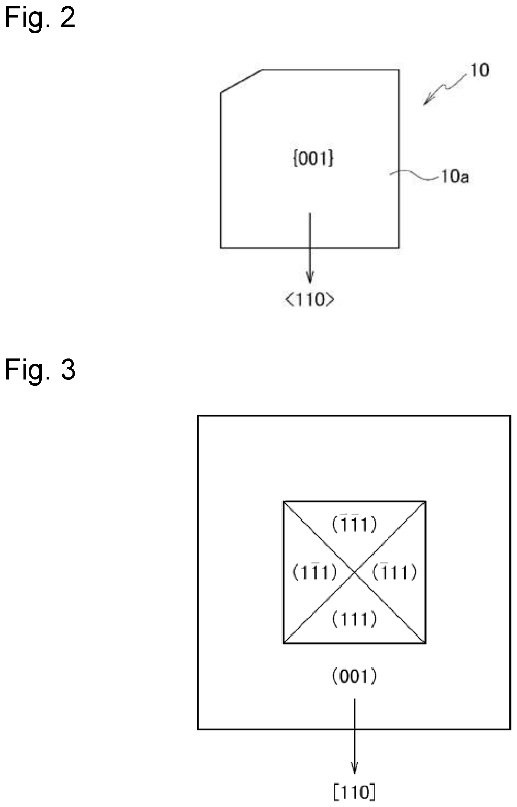

FIG. 2 is a plan view illustrating the substrate 10 to be processed by the processing device 110. The substrate 10 has a rectangular {001} plane serving as the main surface 10a, and the direction indicated by the arrow is defined as a <110> direction. The substrate 10 may have, for example, a (100) plane serving as the main surface 10a, and the direction indicated by the arrow may be defined as a [110] direction. In this case, an orientation flat may be provided by notching the corner in the [0-10] direction of the rectangular substrate 10 to indicate the crystal orientation of the substrate 10. Due to limitation on signs that can be used in this specification, an upper line attached to a number for displaying the Miller index will be replaced by a minus sign "-" before the number, for the sake of convenience.

FIG. 3 is a schematic diagram illustrating arrangement of the {111} plane on the substrate 10. The {111} plane is a cleavage plane of the diamond single crystal substrate 10. FIG. 3 is a plan view of the crystal structure of the substrate 10 with the (001) plane serving as the main surface 10a, viewed from the main surface 10a. The figure also illustrates the orientation of [110]. The {111} plane constitutes the slopes (111), (-111), (-1-11), and (1-11) in a square pyramid protruding from the (100) plane with the (001) plane serving as the bottom surface.

Here, a carbon atom in a diamond single crystal constituting the substrate 10 is covalently bonded to adjacent carbon elements by arms of sp3 hybrid orbitals extending in the direction of the four vertexes of a regular tetrahedron centered on the carbon atoms. The carbon atoms covalently bonded to the adjacent four carbon atoms form a body-centered cubic lattice called a diamond structure. It is known that single crystal diamond is very hard because carbon atoms form covalent bonds with four neighboring carbon atoms in the diamond structure. However, a carbon atom is covalently bonded to one neighboring carbon atom in the <111> direction by a single arm of sp3 hybridization orbital. Therefore, carbon atoms can be separated relatively easily by breaking only this single arm covalent bond in the {111} plane direction orthogonal to the <111> direction, and this {111} plane becomes a cleavage plane.

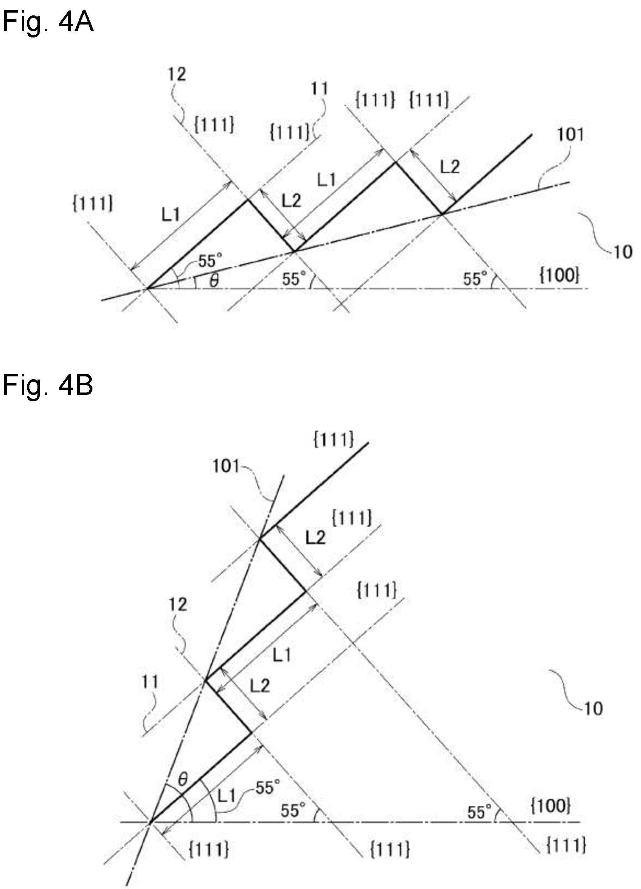

FIG. 4 is a diagram illustrating a method of forming cleavage along a plane 101 at an arbitrary angle θ with respect to the {001} plane of the main surface 10a. FIG. 4A is for the case of θ ≤ 55°, and FIG. 4B is for the case of θ ≥ 55°. 55° is an angle formed by the {111} plane of the cleavage plane and the {001} plane of the main surface 10a. As mentioned above, since the substrate 10 formed of the single crystal diamond has the {111} plane as the cleavage plane, the {111} planes of the cleavage planes can be connected to form cleavage along the plane 101. Specifically, as illustrated in FIG. 4A and FIG. 4B, setting a length ratio between sides along the first crystal face 11 and the second crystal face 12 that constitute the {111} plane makes it possible to form cleavage along the plane 101 at an arbitrary angle θ with respect to the {001} plane.

In FIG. 4, the length L1 of the first crystal face and the length L2 of the second crystal face for forming a processing layer along the 101 plane at an angle θ can be each determined by equation (1) where L2 is a ratio of the length obtained when L1 is set to 1, in the case of an angle θ ≤ 55° illustrated in FIG. 4A and the case of an angle θ ≥ 55° illustrated in FIG. 4B.
[Mathematical Formula 1] $\left|L2\right| = \frac{2 sin 55 ′}{cos 55 ′ \times \left(tan 55′+tanθ\right)} - 1$

The results obtained using equation (1) for a representative angle θ are shown in Table 1.

**[Table 1]**

| θ (deg) | L2 | θ (deg) | L2 |
|---|---|---|---|
| 0 | 1 | 55 | 0 |
| 10 | 0.7802 | 60 | 0.0962 |
| 20 | 0.5938 | 70 | 0.3160 |
| 30 | 0.4242 | 80 | 0.5977 |
| 40 | 0.2598 | 90 | 1 |
| 50 | 0.0902 | 100 | 1.6731 |
| 55 | 0 | 110 | 3.165 |

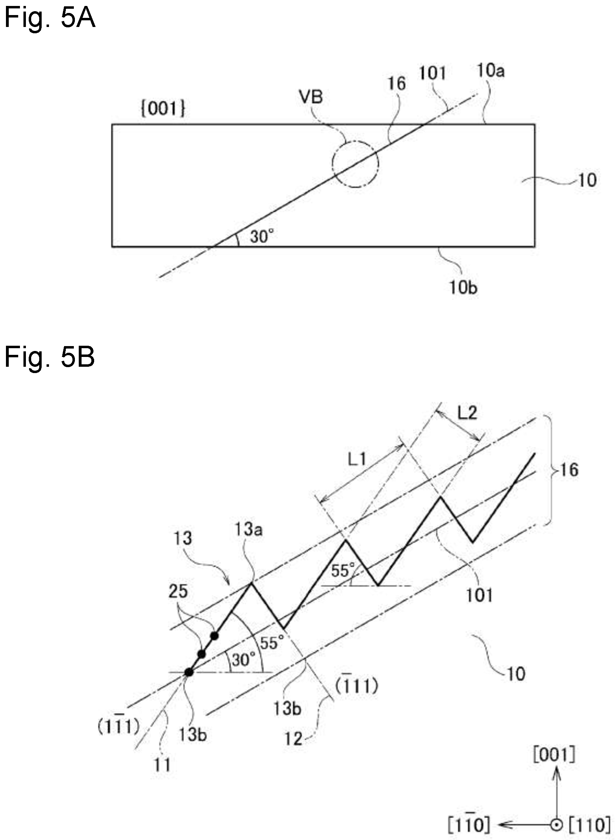

FIGs. 5 are diagrams illustrating a processing method of the present embodiment. FIG. 5A is a cross-sectional view illustrating a modified layer 16 formed by the processing method of the present embodiment, and FIG. 5B is an enlarged cross-sectional view of a region VB in FIG. 5A. As illustrated in FIG. 5A, the substrate 10 is composed of a single crystal diamond having a predetermined thickness between a top surface serving as the main surface 10a having a (001) plane among the {001} plane, and a bottom surface 10b parallel to the top surface.

The processing method of the present embodiment forms the modified layer 16 along the plane 101 set at θ = 30° with respect to the main surface 10a. FIG. 5A shows a cross-section of the substrate 10 cut by a flat plane orthogonal to the main surface 10a and the plane 101. Here, the modified layer 16, which is formed along the plane 101, which intersects the main surface 10a and the bottom surface 10b at an angle of 30°, is illustrated. The modified layer 16 includes processing marks made of graphite formed by condensing the laser light B by the laser condenser 119 of the processing device 110, and cleavage formed along the {111} plane around the processing marks. The laser light B emitted onto the substrate 10 is controlled so that the modified layer 16 is formed along the plane 101, and the cleavages constituting the modified layer 16 are connected and extend along the plane 101.

As illustrated in FIG. 5B, in the modified layer 16 extending along the plane 101, on a (1-11) plane of a first crystal face 11 and a (-111) plane of a second crystal face 12 for forming a wedge structure 13 whose tip becomes thinner toward the main surface 10a inside the substrate 10 among the crystal faces constituting the {111} plane, each processing mark 25 is formed between an end 13b and a tip 13a of the wedge structure 13 at predetermined intervals. The (1-11) plane of the first crystal face 11 and the (-111) plane of the second crystal face 12 have an angle of 55° with respect to the {001} plane, and the wedge structure 13 is formed by the (1-11) plane of the first crystal face 11 and the (-111) plane of the second crystal face 12 converging toward the main surface 10a. Around the processing mark 25, cleavage occurs along the {111} plane, and adjacent processing marks 25 are connected to each other by cleavage, forming cleavage that extends along the modified layer 16. Since the modified layer 16 is formed along the plane 101, the cleavage extends along the plane 101. As mentioned above, in a flat plane orthogonal to the main surface 10a and the plane 101, the modified layer 16 is composed of a first side of length L1 formed along the first crystal face 11 and a second side of length L2 formed along the second crystal face 12, which can be set by an angle **θ** of the plane 101.

In the present embodiment, the main surface 10a is the (001) plane among the {001} plane, and the present embodiment describes an example in which the first crystal face 11 and the second crystal face 12 are the (1-11) plane and the (-111) plane, respectively, but it is not limited to this example. The main surface 10a may not be a plane belonging to the {001} plane. The first crystal face 11 and the second crystal face 12 may not be the (1-11) plane and the (-111) plane as long as they can be any pair of crystal faces that can form the wedge structure 13 whose tip becomes thinner so as to face the main surface 10a inside the substrate 10 within the {111} plane.

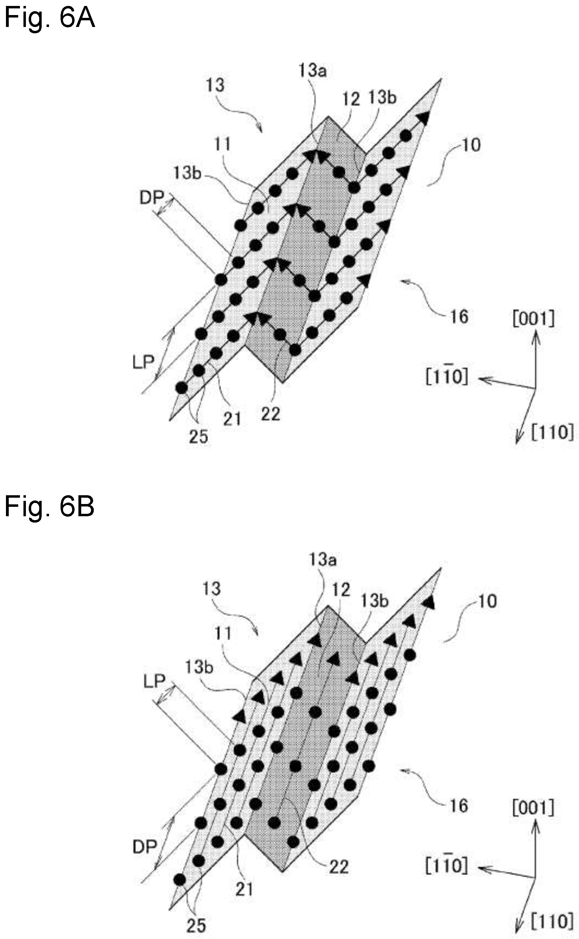

FIGs. 6 are diagrams illustrating a scanning method of laser light B. FIG. 6A is a diagram illustrating the scanning method of the processing method of the present embodiment, and FIG. 6B is a diagram illustrating the scanning method of the processing method of a variation. As illustrated in FIG. 6A, in the processing method of the present embodiment, the processing marks 25 formed between the end 13b and the tip 13a of the wedge structure 13 are composed of a first scanning line 21 and a second scanning line 22 of the processing marks 25 extending from the end 13b toward the tip 13a of the wedge structure 13, each formed along the first crystal face 11 and the second crystal face 12, which are the {111} planes, respectively. Specifically, the first scanning line 21 is composed of the processing marks 25 formed at intervals of a dot pitch DP from the end 13b toward the tip 13a of the wedge structure 13 along the first crystal face 11. The second scanning line 22 is composed of the processing marks 25 formed at intervals of a dot pitch DP from the end 13b toward the tip 13a of the wedge structure 13 along the second crystal face 12. The first scanning line 21 and the second scanning line 22 converge at the tip 13a of the wedge structure 13 and are connected. The arrows in the first scanning line 21 and the second scanning line 22 in FIG. 6A indicate the scanning directions of the laser light B that forms the processing marks 25 at the dot pitch DP.

Once the formation of the first scanning line 21 and the second scanning line 22 is completed, the first scanning line 21 and the second scanning line 22 are additionally formed at a position spaced apart by the line pitch LP in the direction in which the tip 13a of the wedge structure 13 extends. Repeating such operations makes it possible to form the modified layer 16 in a predetermined area of the main surface 10a of the substrate 10. When the substrate 10 is stripped off by the plane 101 at an arbitrary angle **θ** with respect to the (001) plane {001} of the main surface, a modified layer along the plane at an arbitrary angle **θ** can be formed by setting the length L1 of the first scanning line 21 that is the first side and the length of the second scanning line 22 that is the second side, and sequentially moving the end 13b and tip 13a of the wedge structure at a distance of this setting. Formation of the modified layer 16 in this way separates the substrate 10 by cleavage formed along the plane 101 at an arbitrary angle θ with respect to the {001} plane of the main surface, and thus the substrate 10 can be stripped off.

The scanning method of the variation illustrated in FIG. 6B illustrates the relationship between the dot pitch DP and the line pitch LP at which the first scanning line 21 and the second scanning line 22 form processing marks 25 on the first crystal face 11 and the second crystal face 12, which is different from the scanning method of the embodiment of FIG. 6A, in which the first scanning line 21 and the second scanning line 22 are scanned from the end 13b toward the tip 13a of the wedge structure 13 along the first crystal face 11 and the second crystal face 12, respectively.

Specifically, the first scanning line 21 is composed of the processing marks 25 formed at intervals of the dot pitch DP on the first crystal face 11 of a predetermined length L1. The second scanning line 22 is composed of the processing marks 25 formed at intervals of the dot pitch DP on the second crystal face 12 of a predetermined length L2. Once the first scanning line 21 and the second scanning line 22 are formed, the focal position of the laser light B is sequentially moved along a direction 122 toward the tip 13a of the wedge structure 13, and the first scanning line and the second scanning line are further formed at positions spaced apart by the line pitch LP. The arrows of the first scanning line 21 and the second scanning line 22 in FIG. 6B indicate the scanning direction of the laser light B.

Repeating such operations makes it possible to form the first scanning line 21 and the second scanning line 22 from the end 13b to the tip 13a of the wedge structure 13 along the first crystal face 11 and the second crystal face 12. The processing marks 25 formed on the first crystal face 11 and the second crystal face 12 by the first scanning line 21 and the second scanning line 22 respectively converge at the tip 13a of the wedge structure 13 and are connected. The modified layer 16 is formed from the end 13b toward the tip 13a of the wedge structure 13.

In the scanning method of the variation illustrated in FIG. 6B, in the respective scanning lines of the first scanning line 21 and the second scanning line 22, the processing marks 25 are formed at a predetermined depth from the main surface 10a. Therefore, compared to the scanning method of the present embodiment in which the first scanning line 21 and the second scanning line 22 are formed from the end 13b toward the tip 13a of the wedge structure 13 illustrated in FIG. 6A, the first scanning line 21 and the second scanning line 22 can be scanned within the first crystal face 11 and the second crystal face 12 without moving the focal position of the laser light B in the depth direction, which makes it possible to shorten processing time.

As described above, according to the processing method of the present embodiment, the modified layer 16 can be formed along the plane 101 having an angle with respect to the {001} plane toward the main surface 10a on the single crystal diamond substrate 10. Thus, the modified layer 16 can be formed along the plane 101 at an arbitrary angle with respect to the {001} plane of the main surface 10a on the single crystal diamond substrate 10. In the modified layer 16, cleavage surfaces connected along the plane 101 extend. For this reason, when the single crystal diamond substrate 10 is stripped off at the cleavage plane, it can be separated along the plane 101.

According to the processing method of the present embodiment, it is possible to separate the single crystal diamond substrate 10 along a plane at an arbitrary angle θ with respect to the {001} plane of the main surface 10a, and thus the single crystal diamond substrate 10 can be effectively used without constraining the cleavage direction of the {111} plane. Moreover, since the separated single crystal diamond substrate 10 can be formed with a plane other than the {111} plane serving as the main surface 10a, the range of choices for using single crystal diamond is also expanded.

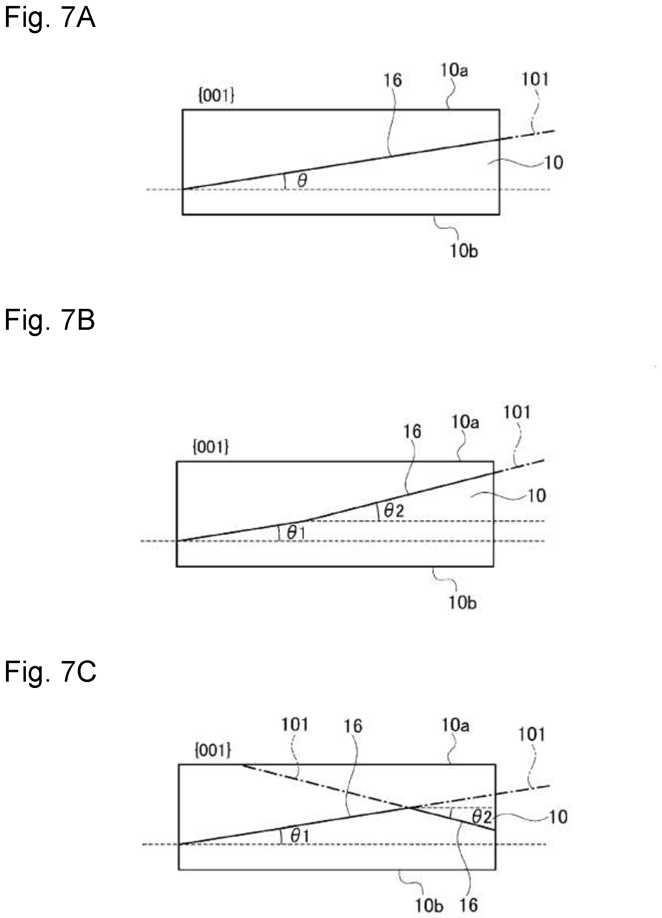

FIG. 7 is a diagram illustrating an aspect of the modified layer 16 formed on the single crystal diamond substrate 10. As illustrated in FIG. 7A, the present embodiment describes an example in which the modified layer 16 is formed along a plane at an arbitrary angle θ with respect to the {001} plane of the main surface 10a, but the present embodiment is not limited thereto. For example, as illustrated in FIG. 7B, the modified layer 16 may be formed so that a plane formed along a first angle θ1 and a plane formed along a second angle θ2 are connected to each other with respect to the main surface 10a. Also, as illustrated in FIG. 7C, the second angle θ2 may be a negative value.

The modified layer 16 can also be formed along not only a flat plane such as a crystal face but also along a curved plane. In such cases, the processing marks 25 are formed by two-dimensional scanning with laser light B along the curved plane, and the cleavages formed around the processing marks 25 are connected, thus forming the modified layer 16 so that the cleavage planes are formed along the curved plane.

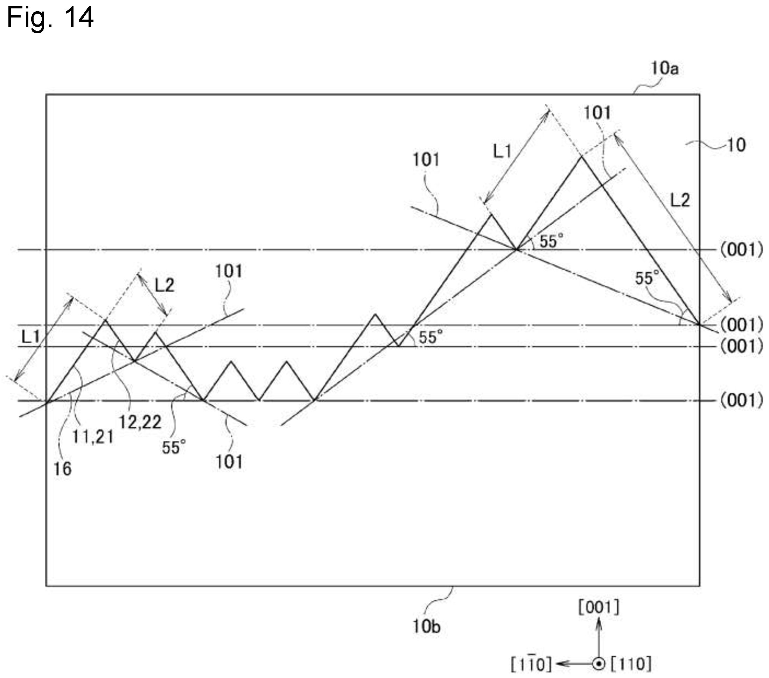

FIG. 14 is a diagram illustrating a method of providing a modified layer that includes multiple planes 101 having different angles θ with respect to the {001} plane toward the {001} plane of the main surface 10a, forming cleavage along each of the multiple planes 101 having different angles θ, and forming the modified layer 16 into a three-dimensional structure. FIG. 14 illustrates a cross-section of the substrate 10 cut along a flat plane orthogonal to the {001} plane of the main surface 10a and the plane 101 other than the {111} plane. Separation of the substrate with this modified layer 16 makes it possible to obtain a diamond substrate having a surface of a three-dimensional structure. As illustrated in FIG. 14, on the first crystal face 11 and the second crystal face 12, having an angle of 55° with respect to the (001) plane parallel to the main surface 10a, the first scanning line 21 and the second scanning line 22 are formed, respectively. At this time, as illustrated in FIG. 4, when the ratio between the length L1 of the first crystal face and the length L2 of the second crystal face is the same for all wedge structures, a linear modified layer 16 is formed. In the method illustrated in FIG. 14, the modified layer 16 having a three-dimensional structure is formed by including wedge structures having different ratios between the length L1 of the first crystal face and the length L2 of the second crystal face. In the method illustrated in FIG. 14, when L1 > L2 is satisfied, the modified layer 16, which rises to the right in the figure and extends along an arbitrary angle toward the main surface 10a, is formed. When L1 < L2 is satisfied, the modified layer 16, which rises to the left in the figure and extends along an arbitrary angle toward the main surface 10a, is formed. When L1 = L2 is satisfied, the modified layer 16 is formed along the (001) plane parallel to the main surface 10a. By continuously forming the multiple modified layers 16 having different angles toward the main surface 10a, the modified layer 16 having a three-dimensional structure is formed. In the modified layer 16 having a three-dimensional structure, at least one part may be formed so as to extend along an arbitrary angle toward the main surface 10a. As illustrated in FIG. 14, the modified layer 16 is not formed up to the main surface 10a of the substrate, penetrates both surface parts of the substrate, and is formed inside the substrate. The substrate may be stripped off to form two pieces by the modified layer 16.

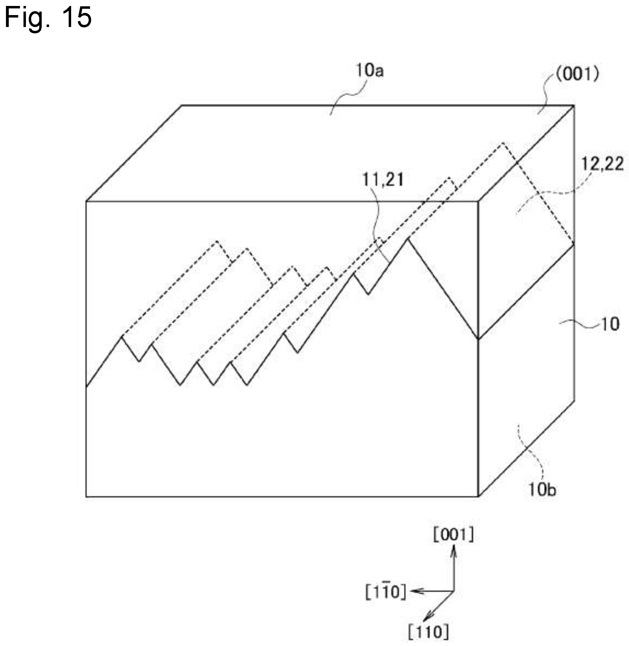

FIG. 15 is a perspective schematic diagram illustrating the modified layer 16 formed by the method illustrated in FIG. 14. When the modified layer 16 having a three-dimensional structure is formed inside the substrate 10, separation of the substrate 10 with this modified layer 16 makes it possible to obtain a diamond substrate having a surface of a three-dimensional structure.

### EXAMPLE

### (Experiment 1)

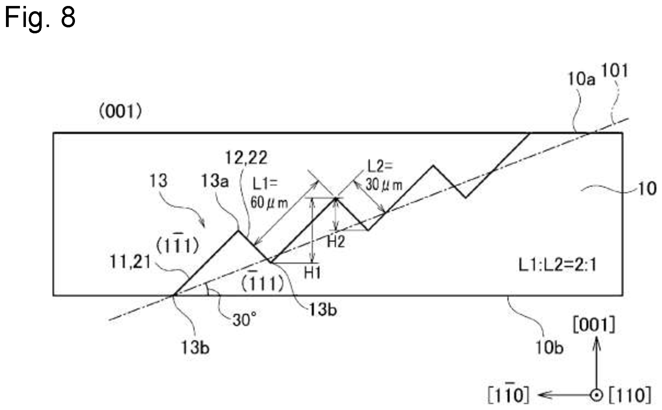

FIG. 8 is a diagram illustrating a processing method of Experiment 1 to which the processing method of the present embodiment is applied. FIG. 8 illustrates a cross-section of the substrate 10 cut along a flat plane orthogonal to the {001} plane of the main surface 10a and the plane 101 other than the {111} plane.

In Experiment 1, using the scanning method of the laser light B illustrated in FIG. 6B, the wedge structure 13 whose tip becomes thinner is formed so as to face the (001) plane of the main surface 10a inside the substrate 10 by the first crystal face 11 of the (1-11) plane and the second crystal face 12 of the (-111) plane among the {111} plane, so that the modified layer 16 is formed along the plane 101 that forms an angle of 30° with respect to the (001) plane of the main surface 10a. In the wedge structure 13, when sides extending from the end 13b to the tip 13a in the first crystal face 11 and the second crystal face 12 are defined as the first side and the second side, respectively, the first side satisfies a length L1 = 60 µm, and the second side satisfies a length L2 = 30 µm. In this case, there is a relationship of L1: L2 = 2: 1 between the length L1 of the first side and the length L2 of the second side. The wedge structure 13 has a height H1 = 50 µm from the end 13b to the tip 13a of the first crystal face 11 corresponding to the first side, and a height H2 = 25 µm from the end 13b to the tip 13a of the second crystal face 12 corresponding to the second side.

In Experiment 1, along the first crystal face 11 and the second crystal face 12 constituting the above-described wedge structure 13, in Experiment 1-1 and Experiment 1-2, the first scanning line 21 and the second scanning line 22 were formed in accordance with the conditions of Table 2 under two conditions: a dot pitch DP = 15 µm and 25 µm, and under the condition of a line pitch LP = 1.1 µm. Then, the modified layer 16 including the processing marks 25 constituting the first scanning line 21 and the second scanning line 22 and the cleavage generated around the processing marks 25 was formed.

**[Table 2]**

| Experiment | | | Experiment 1-1 | Experiment 1-2 |
|---|---|---|---|---|
| Figure No. | | | FIG. 9(a) | FIG. 9(b) |
| Modified Layer Plane Angle | | deg | 30 | |
| Wavelength | | nm | 1030 | |
| Pulse Width | | ps | 10 | |
| Pulse Energy | | µJ | 1.5 | |
| Oscillatory Frequency | | kHz | 0.25 | 0.2 |
| Scanning Velocity | First Scanning Line | mm/s | 3.75 | 5 |
| | Second Scanning Line | mm/s | 3.75 | 5 |
| Dot Pitch DP | First Scanning Line | µm | 15 | 25 |
| | Second Scanning Line | µm | 15 | 25 |
| Line Pitch LP | First Scanning Line | µm | 11 | 11 |
| | Second Scanning Line | µm | 11 | 11 |
| First Scanning Line Length | L1 | µm | 60 | 60 |
| Second Scanning Line Length | L2 | µm | 30 | 30 |
| Height H1 | | µm | 50 | 50 |
| Height H2 | | µm | 25 | 25 |

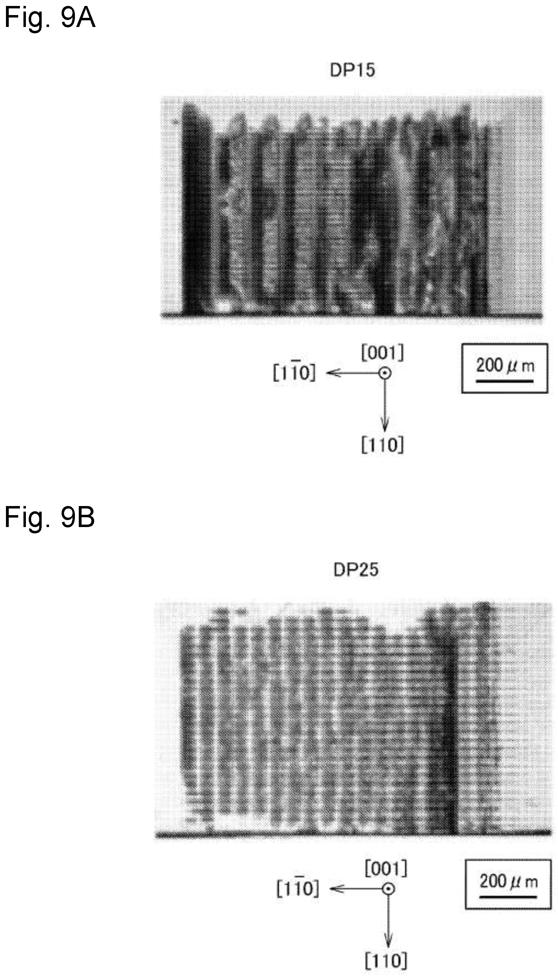

FIG. 9 are photomicrographs of the substrate 10 processed by the processing method of Experiment 1. The photomicrographs are taken by a differential interference microscope. FIG. 9A shows the results of Experiment 1-1, and FIG. 9B shows the results of Experiment 1-2. FIG. 9A of Experiment 1-1 has a dot pitch DP = 15 µm, and FIG. 9B of Experiment 1-2 has a dot pitch DP = 25 µm. In FIG. 9A, cleavage is formed around the processing marks 25, but in FIG. 9B, it is observed that the graphitization and cleavage on the side of the second crystal face 12 are insufficient.

### (Experiment 2)

In Experiment 2, the processing method as illustrated in FIG. 8 was applied using the scanning method of the laser light B illustrated in FIG. 6B in the same manner as in Experiment 1. However, Experiment 2, in which processing was performed under the conditions of Table 3, is different from Experiment 1 in which processing was performed under the conditions of Table 2. Table 3 shows the processing conditions of Experiment 2-1, Experiment 2-2, and Experiment 2-3, in which the settings of the dot pitch DP and the line pitch LP were changed. Other configurations of Experiment 2 are the same as those of Experiment 1.

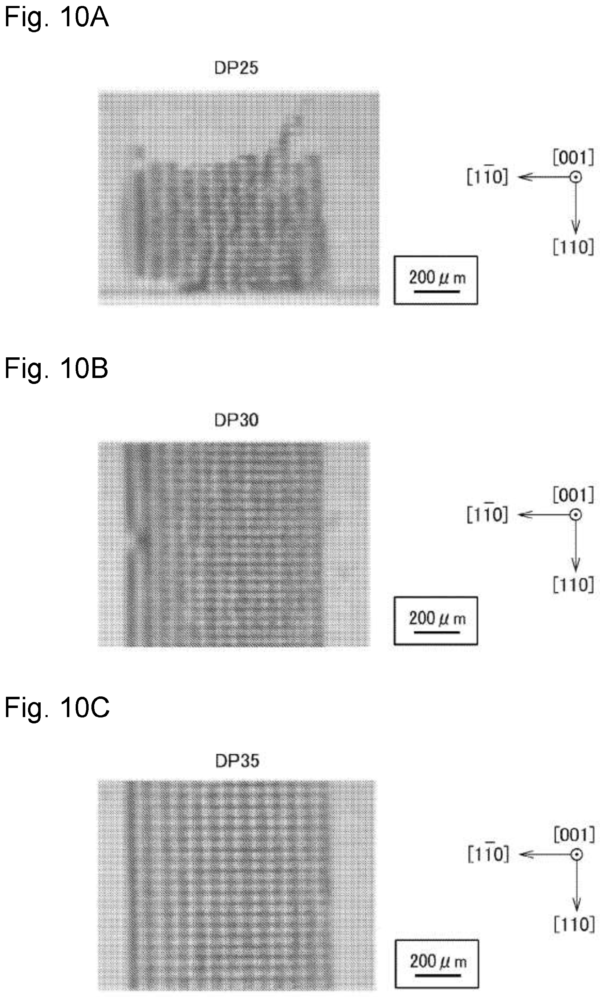

FIG. 10 are photomicrographs of the substrate 10 processed by the processing method of Experiment 2. FIG. 10A shows a dot pitch DP = 25 µm in Experiment 2-1, FIG. 10B shows a dot pitch DP = 30 µm in Experiment 2-2, and FIG. 10C shows a dot pitch DP = 35 µm in Experiment 2-3. In all of FIG. 10A, FIG. 10B, and FIG. 10C, it is observed that graphite at the processing mark 25 and the cleavage around the processing mark 25 are sufficiently formed. In FIG. 10B in which a dot pitch DP = 30 µm is satisfied, it is observed that the cleavages are most connected.

**[Table 3]**

| Experiment | | | Experiment 2-1 | Experiment 2-2 | Experiment 2-3 |
|---|---|---|---|---|---|
| Figure No. | | | FIG. 10(a) | FIG. 10(b) | FIG. 10(c) |
| Modified Layer Plane Angle | | deg | 30 | | |
| Wavelength | | nm | 1030 | | |
| Pulse Width | | ps | 10 | | |
| Pulse Energy | | µJ | 1.5 | | |
| Oscillatory Frequency | | kHz | 0.25 | 0.2 | 0.15 |
| Scanning Velocity | First Scanning Line | mm/s | 6.25 | 6 | 5.25 |
| | Second Scanning Line | mm/s | 6.25 | 6 | 5.25 |
| Dot Pitch DP | First Scanning Line | µm | 25 | 30 | 35 |
| | Second Scanning Line | µm | 25 | 30 | 35 |
| Line Pitch LP | First Scanning Line | µm | 1.2 | 1.2 | 1.2 |
| | Second Scanning Line | µm | 0.6 | 0.6 | 0.6 |
| First Scanning Line Length | L1 | µm | 60 | 60 | 60 |
| Second Scanning Line Length | L2 | µm | 30 | 30 | 30 |
| Height H1 | | µm | 50 | 50 | 50 |
| Height H2 | | µm | 25 | 25 | 25 |

### (Experiment 3)

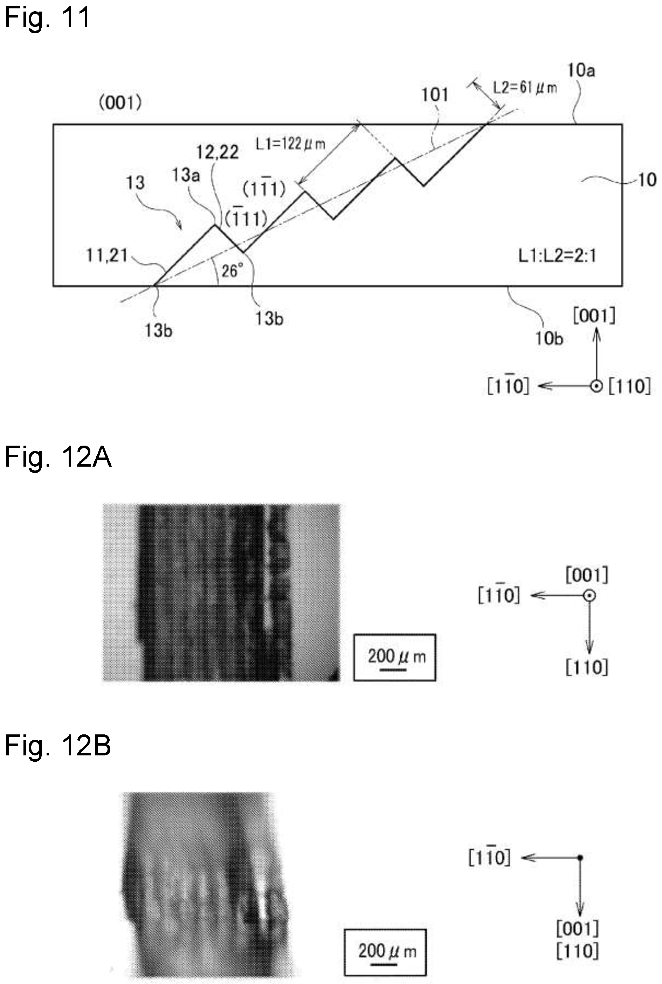

FIG. 11 is a diagram illustrating a processing method of Experiment 3 to which the processing method of the present embodiment is applied. FIG. 11 illustrates a cross-section of the substrate 10 cut along a flat plane orthogonal to the (001) plane of the main surface 10a and the plane 101 that forms an angle of 26° with respect to the main surface 10a.

In Experiment 3, the wedge structure 13 whose tip becomes thinner is formed so as to face the (001) plane of the main surface 10a inside the substrate 10 by the first crystal face 11 of the (1-11) plane and the second crystal face 12 of the (-111) plane among the {111} plane, so that the modified layer 16 is formed along the plane 101 that forms an angle of 26° with the (001) plane of the main surface 10a and the bottom surface 10b. In the wedge structure 13, when sides extending from the end 13b to the tip 13a in the first crystal face 11 and the second crystal face 12 are defined as the first side and the second side, respectively, there is a relationship of L1: L2 = 2: 1 between the first side: a length L1 = 122 µm and the second side: a length L2 = 61 µm.

In Experiment 3, along the first crystal face 11 and the second crystal face 12 constituting the above-described wedge structure 13, the first scanning line 21 and the second scanning line 22 were formed in accordance with the conditions of Table 4 using the scanning method of the laser light B illustrated in FIG. 6A, which was different from Experiment 1 and Experiment 2. As illustrated in Table 4, for the first scanning line 21 and the second scanning line 22, the first scanning line 21 corresponding to the first side satisfied the dot pitch DP = 2 µm, the second scanning line 22 corresponding to the second side satisfied the dot pitch DP = 1 µm, and the dot pitch DP of the second side was shorter than the dot pitch DP of the first side. Then, the modified layer 16 including the processing marks 25 constituting the first scanning line 21 and the second scanning line 22 and the cleavage generated around the processing marks 25 was formed.

FIG. 12 are photomicrographs of the substrate 10 processed by the processing method of Experiment 3. FIG. 12A and FIG. 12B illustrate the substrate 10 viewed from different angles. In the modified layer 16, it is observed that cleavages are connected and formed in both the dot pitch DP direction and the line pitch LP direction.

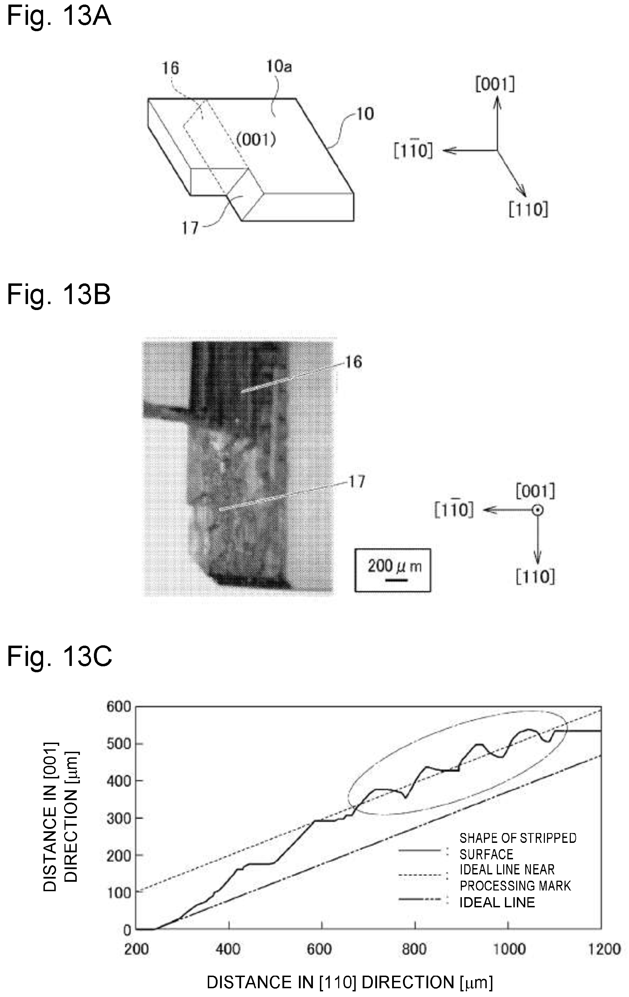

FIGs. 13 are views illustrating the substrate 10 separated by the processing method of Experiment 3. FIG. 13A is an overhead view of the separated substrate 10, and FIG. 13B is a photograph of the separated part of the separated substrate 10. FIG. 13C is a graph showing the measurement results of the surface shape of the stripped surface formed by separation. As mentioned above, the modified layer 16 was formed along the plane 101 of the substrate 10. Furthermore, the laser light B was emitted from the side wall to develop the cleavage and the modified layer 16 was stripped off with external force to separate the substrate 10.

As illustrated in FIG. 13A, a part of the substrate 10 is separated and removed by a stripped surface 17 formed along the modified layer 16 formed on the substrate 10. As illustrated in FIG. 13B, the stripped surface 17 is formed to be continuously connected to the modified layer 16, and it is observed that the stripped surface 17 was formed on the modified layer 16. Referring to FIG. 13C, it is observed that in the part surrounded by the ellipse, the stripped surface 17 is slightly displaced from the ideal line of the plane 101, but is formed along the ideal line near the processing mark 25.

**[Table 4]**

| Experiment | | | Experiment 3 |
|---|---|---|---|
| Modified Layer Plane Angle | | deg | 26 |
| Wavelength | | nm | 1030 |
| Pulse Width | | ps | 10 |
| Pulse Energy | | µJ | 1.5 |
| Oscillatory Frequency | | kHz | 0.2 |
| Scanning Velocity | First Scanning Line | mm/s | 0.4 |
| | Second Scanning Line | mm/s | 0.2 |
| Dot Pitch DP | First Scanning Line | µm | 2 |
| | Second Scanning Line | µm | 1 |
| Line Pitch LP | First Scanning Line | µm | 20 |
| | Second Scanning Line | µm | 29 |
| First Scanning Line Length | L1 | µm | 122 |
| Second Scanning Line Length | L2 | µm | 61 |
| Height H1 | | µm | 70 |
| Height H2 | | µm | 35 |

The embodiments and experiments have been described above. However, these embodiments and experiments are merely examples for embodying the technical concept of the present invention, and the scope of the invention is not intended to be limited thereto. The embodiments may be possible in various other forms, and various omissions, substitutions, and changes may be made without departing from the gist of the invention.

This application claims priority under Japanese Patent Application No. 2023-191748, filed November 9, 2023 and priority under Japanese Patent Application No. 2024-113206, filed July 16, 2024, and the entire contents of which are hereby incorporated by reference.

### REFERENCE SIGNS LIST

- 10: Substrate
- 10a: Main surface
- 10b: Bottom surface
- 11: First crystal face
- 12: Second crystal face
- 13: Wedge structure
- 13a: Tip (of wedge structure)
- 13b: End (of wedge structure)
- 16: Modified layer
- 21: First scanning line
- 22: Second scanning line
- 25: Processing mark
- 101: Plane

## Claims

1. A method of processing diamond, the method comprising:
a step of arranging a laser condenser configured to condense laser light, to face a {001} plane of a main surface of a single crystal diamond substrate; and
a step of forming a modified layer extending at an angle with respect to the {001} plane toward the main surface of the substrate by condensing the laser light inside the substrate by the laser condenser,
wherein, in the step of forming the modified layer, the modified layer, which includes processing marks obtained by condensing the laser light by the laser condenser and pyrolyzing diamond into graphite and cleavages on a {111} plane formed around the processing marks, is formed along a plane having an angle with respect to the {001} plane toward the main surface of the substrate.

2. The method of processing diamond according to claim 1, wherein, in the step of forming the modified layer, the modified layer is formed so that cleavage planes formed along crystal faces constituting the {111} plane are connected to each other and extend along a plane having an angle with respect to the {001} plane toward the main surface of the substrate.

3. The method of processing diamond according to claim 1 or 2, wherein, in the step of forming the modified layer, the laser light is condensed by the laser condenser, a first scanning line and a second scanning line formed of the processing marks are formed from an end toward a tip of each wedge structure in a first crystal face and a second crystal face that form a wedge structure whose tip becomes thinner toward the main surface inside the substrate among the crystal faces constituting the {111} plane, and the first scanning line and the second scanning line converge at the tip of the wedge structure to be connected to each other.

4. The method of processing diamond according to claim 3, wherein the first scanning line and the second scanning line include a first side and a second side that are adjacent to each other, and a length ratio between the first side and the second side is set with respect to an angle of the modified layer toward the main surface.

5. The method of processing diamond according to claim 3, wherein, in the step of forming the modified layer, after the first scanning line and the second scanning line are formed, the first scanning line and the second scanning line are further formed in a direction in which the tip of the wedge structure extends so as to be spaced apart by a predetermined interval.

6. The method of processing diamond according to claim 1 or 2, wherein, in the step of forming the modified layer, the laser light is condensed by the laser condenser, and, in a first crystal face and a second crystal face that form a wedge structure whose tip becomes thinner toward the main surface inside the substrate among the crystal faces constituting the {111} plane, a first scanning line and a second scanning line formed of the processing marks are formed in a direction in which each tip of the wedge structure extends.

7. The method of processing diamond according to claim 6, wherein, in the step of forming the modified layer, after the first scanning line and the second scanning line are formed, the first scanning line and the second scanning line are further formed toward the tip of the wedge structure so as to be spaced apart by a predetermined interval.

8. The method of processing diamond according to claim 1 or 2, wherein, in the step of forming the modified layer, a modified layer including multiple planes having different angles with respect to the {001} plane toward the main surface of the substrate is formed as a modified layer having a three-dimensional structure in which cleavages are each formed along the multiple planes and the multiple planes are connected.

9. The method of processing diamond according to claim 8, wherein, in the step of forming the modified layer, the laser light is condensed by the laser condenser, a first scanning line and a second scanning line formed of the processing marks are formed from an end toward a tip of each wedge structure in a first crystal face and a second crystal face that form a wedge structure whose tip becomes thinner toward the main surface inside the substrate among the crystal faces constituting the {111} plane, the first scanning line and the second scanning line converge at the tip of the wedge structure to be connected to each other, the first scanning line and the second scanning line include a first side and a second side that are adjacent to each other, and the wedge structure having a different length ratio between the first side and the second side that are adjacent to each other is provided.

10. The method of processing diamond according to claim 1 or 2, wherein the substrate is separated by the modified layer.
